# EUROPEAN PATENT SPECIFICATION

(11) **EP 4 318 425 B1**
(45) Date of publication and mention of the grant of the patent: **16.09.2026**
(21) Application number: 21932947.1
(22) Date of filing: 24.03.2021
(51) Int. Cl.: G08B 17/107, G08B 17/113, H10F 55/25, H10W 90/00, H10H 20/857, G01N 21/53, H05K 1/18

(54) **ELEMENT MOUNTING MEANS, ELECTRODE MEANS MANUFACTURING METHOD, AND SMOKE DETECTOR MANUFACTURING METHOD**
ELEMENTMONTAGEMITTEL, ELEKTRODENMITTELHERSTELLUNGSVERFAHREN UND RAUCHDETEKTORHERSTELLUNGSVERFAHREN
MOYEN DE MONTAGE D'ÉLÉMENT, PROCÉDÉ DE FABRICATION DE MOYEN D'ÉLECTRODE ET PROCÉDÉ DE FABRICATION DE DÉTECTEUR DE FUMÉE

(43) Date of publication of application: 07.02.2024
(73) Proprietor: Hochiki Corporation, Shinagawa-ku, Tokyo 141-8660 (JP)
(72) Inventor: TESHIMA, Kiyotaka, Tokyo 141-8660 (JP)
(74) Representative: Laine IP Oy
(86) International application number: PCT/JP2021/012127
(87) International publication number: WO 2022/201337

(56) References cited:
- EP-A1- 3 454 312
- DE-A1- 102012 209 100
- JP-A- 2000 236 102
- JP-A- 2001 126 165
- JP-A- 2009 016 369
- JP-A- H02 222 096
- US-A1- 2011 260 876

## Description

### Technical Field

The present invention relates to a method for manufacturing an electrode portion.

### Background Art

In the related art, a smoke detector has been known that detects smoke in a smoke detection space by receiving scattered light caused by the scattering of light from a light emitting element by the smoke, using a light receiving element (for example, refer to PTL 1). Further, a photoelectric smoke sensor has been known (for example, refer to PTL 2). Furthermore, an optical fire detector for use in buildings has been known. The fire detector has LED and photodiode arranged on sections of printed circuit board, where sections of printed circuit boar are arranged in angled position relative to surface extension of printed circuit board (for example, refer to PTL 3). Even further, a light receiving module that can suitably block electromagnetic noise and external light has been known (for example, refer to PTL 4). Yet further, an electronic component capable of increasing an anti-electromagnetic noise property of a photodetecting component and preventing degradation in appearance and reducing the size has been known (for example, refer to PTL 5). Additionally, a light receiver device having a shielding device extending on a back side of a substrate has been known (for example,

### Citation List

### Patent Literature

Patent Literature 1: Laid-Open Patent Publication in Japan No. 2011-248547;
Patent Literature 2: Laid-Open Patent Publication in Japan JP H02 222096 A;
Patent Literature 3: Laid-Open Patent Publication in Germany No. DE 102012209100 A;
Patent Literature 4: Laid-Open Patent Publication in Japan No. JP 2009-016369 A;
Patent Literature 5: Laid-Open Patent Publication in Japan No. JP 2000-236102 A;
Patent Literature 6: Laid-Open Patent Publication in the USA No. US 2011/260876 A1.

Patent literature 1 relates to an optoelectronic smoke sensor in which the number of separate parts is reduced to reduce the time of assembly. **In** the document a metal thin plate having a predetermined pattern integrally moulded with a light emitting element holder and a light receiving element holder is also integrally moulded.

Patent Literature 2 discloses an optical fire detector comprising a light emitter and a light receiver receiving the scattered light of the light emitter, wherein the light emitter and the light receiver are each arranged on a section of a printed circuit board, wherein at least one of two printed circuit board sections is arranged in an angled position relative to a surface extension of the printed circuit board.

Patent Literature 3 discloses a light receiving module comprising: a lead frame having a ground terminal; a light receiving element mounted on the lead frame; and a translucent resin package that covers a part of the lead frame and the light receiving element. A portion of the lead frame extending from the resin package and conducting to the ground terminal is a shield cover that covers at least a part of the resin package.

Patent Literature 4 discloses a structure of an electronic component implemented in a receiver for an infrared light remote control provided in office automation equipment such as home appliances and personal computers. **In** the area of the lead frame on which the semiconductor element is mounted, a plurality of shield portions are formed, that stand up at least at the side surface of the semiconductor element among the semiconductor element and the wiring connected thereto. Patent Literature 5 discloses a light receiver device, comprising a flat substrate having a front side and an back side opposite said front side,a light receiver mounted on said front side of said substrate and a shielding device disposed at least on said back side of said substrate. The shielding device is configured to shield against electromagnetic interference radiation impinging on said light receiver through said substrate.

### Summary of Invention

### Technical Problem

By the way, in the smoke detector of the related art, since the light emitting element and the light receiving element are directly attached to a smoke detection unit body for partitioning a part of the smoke detection space inside the smoke detector, it is necessary to accurately attach each element to a relatively narrow portion for attaching each element (for example, a recess or the like for attaching each element) in the smoke detection unit body, which may be time and labor consuming. Therefore, there has been a demand for a technique for easily attaching the light emitting element and the light receiving element.

The invention is conceived in view of the foregoing problems, and an object of the invention is to provide an element placement unit, a method for manufacturing an electrode portion, and a method for manufacturing a smoke detector capable of easily attaching a light emitting element and a light receiving element.

### Solution to Problem

In order to solve the above-described problems and archive the purposes, an element placement unit according to an example outside of the scope of the claims is an element placement unit for placing a light emitting element and a light receiving element of a smoke detector that detects smoke by receiving scattered light caused by a scattering of light from the light emitting element by the smoke, using the light receiving element, the unit comprises: a light emitting element-side electrode portion having conductivity for placing the light emitting element while electrically connecting the light emitting element; and a light receiving element-side electrode portion having conductivity for placing the light receiving element while electrically connecting the light receiving element, wherein the light emitting element-side electrode portion and the light receiving element-side electrode portion are integrally formed on a common frame body.

The light emitting element-side electrode portion and the light receiving element-side electrode portion may be disposed to correspond to a first element angle forming a scattering angle represented by an intersection angle between a light emitting axis of the light emitting element and a light receiving axis of the light receiving element.

A shield portion functioning as an electromagnetic shield for the light receiving element may be formed integrally with the light emitting element-side electrode portion and the light receiving element-side electrode portion on the common frame body.

The shield portion may be formed by extending from a part of the light receiving element-side electrode portion.

The element placement unit may further comprise an insulating member that holds the light emitting element-side electrode portion and the light receiving element-side electrode portion.

The element placement unit may include a plurality of sets of at least one of the light emitting element-side electrode portions and the light receiving element-side electrode portions.

The light emitting element-side electrode portion and the light receiving element-side electrode portion may include lead portions, and the light emitting element and the light receiving element of the element placement unit are electrically connected to electric circuits of a circuit board of the smoke detector via the lead portions.

A shield portion functioning as an electromagnetic shield for the light receiving element may be formed integrally with the light emitting element-side electrode portion and the light receiving element-side electrode portion on the common frame body, and the shield portion is electrically connected to an electric circuit ground of a circuit board of the smoke detector.

According to the invention, there is provided a method in line with the wording of claim 1.

The dependent claims define further advantageous embodiments. element.

The method may comprise: a step of forming a shield portion integrally with the light emitting element-side electrode portion and the light receiving element-side electrode portion on the common frame body, the shield portion functioning as an electromagnetic shield for the light receiving element.

The method may further comprise: a step of bending the light emitting element-side electrode portion or the light receiving element-side electrode portion according to a scattering angle represented by an intersection angle between a light emitting axis of the light emitting element and a light receiving axis of the light receiving element.

### Advantageous Effects of the Invention

According to the element placement unit outside of the scope of protection, by providing the light emission-side electrode portion and the light reception-side electrode portion, for example, a light emitting element and a light receiving element can be easily attached to a smoke detector. **In** addition, by integrally forming the light emission-side electrode portion and the light reception-side electrode portion on a common frame body, for example, the element placement unit can be easily formed.

According to the element placement unit outside of the scope of protection, by disposing the light emission-side electrode portion and the light reception-side electrode portion so as to correspond to a first element angle forming a scattering angle for example, the scattering angle of an appropriate angle (for example, approximately 60 degrees to 90 degrees) can be reliably and easily formed in the smoke detector.

According to the element placement unit outside of the scope of protection, by integrally forming the shield portion on the frame body, for example, a shield for the light receiving element can be provided in the element placement unit.

According to the element placement unit outside of the scope of protection, by forming the shield portion through extending from a part of the light reception-side electrode portion, for example, the shield portion can be formed integrally with the light reception-side electrode portion, and the shield portion can be easily formed.

According to the element placement unit outside of the scope of protection, by providing an insulating member that holds the light emission-side electrode portion and the light reception-side electrode portion, for example, the light emission-side electrode portion, the light reception-side electrode portion, and the insulating member can be integrated into one unit, and handling can be facilitated.

According to the element placement unit outside of the scope of protection, by including a plurality of sets of at least one of the light emitting element-side electrode portions and the light receiving element-side electrode portions, for example, it is possible to provide a plurality of the light emitting element and a plurality of the light receiving element for one smoke detector, the performance of the smoke detector can be improved. Namely, for example, it is possible to distinguish between white smoke and black smoke in smoke of a fire (namely, distinguish between types of fires (combustion source)) or to distinguish between smoke of a fire and others (for example, dust, steam, oil smoke from cooking, and the like).

According to the element placement unit outside of the scope of protection, by electrically connecting the light emitting element and the light receiving element to electric circuits of a circuit board of the smoke detector via the lead portions of the light emitting element-side electrode portion and the light receiving element-side electrode portion, for example, the light emitting element and the light receiving element can be reliably and easily electrically connected to the electric circuits.

According to the element placement unit outside of the scope of protection, by electrically connecting the shield portion to an electric circuit ground (predetermined circuit ground) of the circuit board of the smoke detector, for example, the electromagnetic shielding effect of the shield portion (the effect of preventing an influence of electrical or magnetic disturbance noise on the element or the effect of reducing the influence) can be improved.

According to the method for manufacturing an electrode portion , by forming the light emission-side electrode portion and by forming the light reception-side electrode portion, for example, the light emitting element and the light receiving element can be easily attached to the smoke detector In addition, by integrally forming the light emission-side electrode portion and the light reception-side electrode portion on the common frame body, for example, the element placement unit can be easily formed.

According to a further method for manufacturing an electrode portion, by forming the light emission-side electrode portion and by forming the light reception-side electrode portion, for example, the light emitting element and the light receiving element can be easily attached to the smoke detector **In** addition, by integrally forming the light emission-side electrode portion and the light reception-side electrode portion on the common frame body, for example, the element placement unit can be easily formed. Further, by disposing the light emission-side electrode portion and the light reception-side electrode portion so as to correspond to a first element angle forming a scattering angle for example, the scattering angle of an appropriate angle (for example, approximately 60 degrees to 90 degrees) can be reliably and easily formed in the smoke detector.

According to an even further method for manufacturing an electrode portion, by forming a shield portion functioning as an electromagnetic shield for the light receiving element, for example, a shield for the light receiving element can be provided.

According to the method for manufacturing an electrode portion, by holding the light emission-side electrode portion and the light reception-side electrode portion using the common insulating member, and by separating the light emission-side electrode portion, the light reception-side electrode portion, and the common insulating member from the common frame body, for example, the light emission-side electrode portion, the light reception-side electrode portion, and the insulating member can be integrated into one unit, and can be easily separated from the common frame body.

According to a further method for manufacturing an electrode portion, by bending the light emission-side electrode portion and the light reception-side electrode portion according to the scattering angle, for example, the scattering angle of an appropriate angle (for example, approximately 60 degrees to 90 degrees) can be reliably and easily formed in the smoke detector.

According to a method for manufacturing an electrode portion outside of the scope of protection, by electrically connecting the element placement unit, in which the light emitting element and the light receiving element are placed to be electrically connected to the light emission-side electrode portion and the light reception-side electrode portion integrally held by the insulating member respectively, to the electric circuits of the circuit board of the smoke detector, so that for example, the light emitting element and the light receiving element can be easily attached to the smoke detector. **In** addition, by electrically connecting via light emission-side lead portions and light reception-side lead portions, for example, the light emitting element and the light receiving element can be reliably and easily electrically connected to the electric circuits.

### Brief Description of Drawings

[FIG. 1] FIG. 1 is a view for describing an installation state of a detector.
[FIG. 2] FIG. 2 is an exploded perspective view of some components of the detector.
[FIG. 3] FIG. 3 is a perspective view of a smoke detection unit body.
[FIG. 4] FIG. 4 is a perspective view of the smoke detection unit body.
[FIG. 5] FIG. 5 is a perspective view of an element placement unit.
[FIG. 6] FIG. 6 is a perspective view of the element placement unit.
[FIG. 7A] FIG. 7A is a front view of the element placement unit.
[FIG. 7B] FIG. 7B is a front view of the element placement unit.
[FIG. 7C] FIG. 7C is a front view of the element placement unit.
[FIG. 8] FIG. 8 is a plan view of the element placement unit.
[FIG. 9] FIG. 9 is a rear view of the element placement unit.
[FIG. 10] FIG. 10 is a bottom view of the element placement unit.
[FIG. 11] FIG. 11 is a right side view of the element placement unit.
[FIG. 12] FIG. 12 is a left side view of the element placement unit.
[FIG. 13] FIG. 13 is a plan view of a plurality of lead frames.
[FIG. 14] FIG. 14 is a plan view of one lead frame.
[FIG. 15] FIG. 15 is a partial enlarged view of FIG. 14.
[FIG. 16] FIG. 16 is a partial enlarged view of FIG. 14.
[FIG. 17] FIG. 17 is a plan view showing a lead frame with a holding member and the like formed thereon.
[FIG. 18] FIG. 18 is a bottom view showing the lead frame with the holding member and the like formed thereon.
[FIG. 19] FIG. 19 is a plan view showing the separated holding member and the like.
[FIG. 20] FIG. 20 is a front view showing a circuit board on which the element placement unit is mounted.

### Description of Embodiments

Hereinafter, an example of an element placement unit, an embodiment of a method for manufacturing an electrode portion, and an example of a method for manufacturing a smoke detector according to the invention will be described in detail with reference to the drawings.

The "element placement unit" is a unit for placing a light emitting element and a light receiving element of a smoke detector that detects smoke by receiving scattered light caused by the scattering of light from the light emitting element by the smoke, using the light receiving element, and includes, for example, a light emitting element-side electrode portion and a light receiving element-side electrode portion.

The "light emitting element-side electrode portion" is a conductive element for placing the light emitting element while electrically connecting the light emitting element, and the "light receiving element-side electrode portion" is a conductive element for placing the light receiving element while electrically connecting the light receiving element. Further, the light emitting element-side electrode portion and the light receiving element-side electrode portion are integrally formed on a common frame body.

Each component of this application will be described by providing an example of a smoke detector installed on a ceiling that is an installation surface.

### (Configuration)

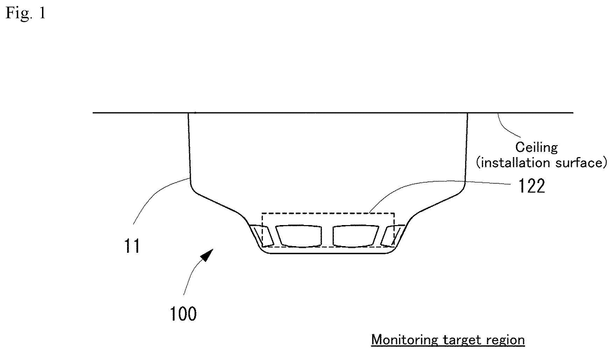

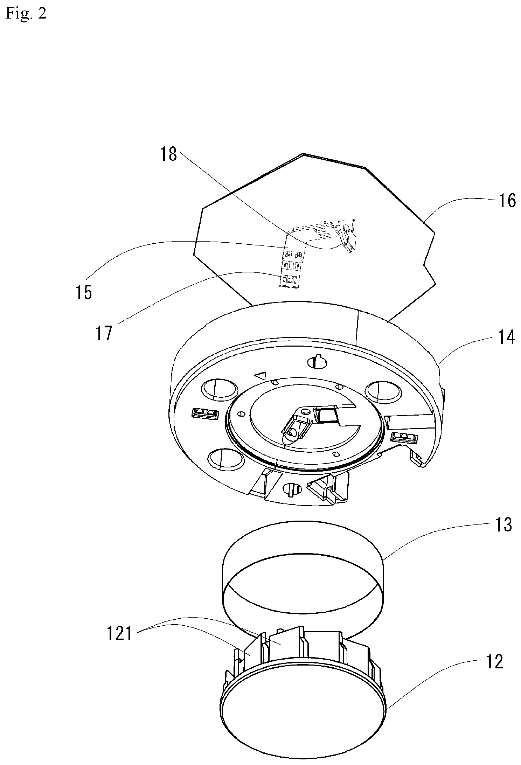

First, a configuration of the detector will be described. FIG. 1 is a view for describing an installation state of the detector, and FIG. 2 is an exploded perspective view of some components of the detector.

A detector 100 in FIG. 1 is a smoke detector that is installed on a ceiling which is an installation surface of a monitoring target region, and that detects a fire occurring in the monitoring target region. Incidentally, the "monitoring target region" is a region to be monitored by the detector 100, and is a concept including, for example, a room, staircase, any other regions, or the like of a building.

Incidentally, in the example of FIG. 1, a case where the detector 100 is directly installed on the installation surface is provided as an example; however, for example, the detector 100 may be configured to be installed via an attachment base.

The detector 100 includes, for example, an outer cover 11 in FIG. 1 and a smoke detection unit cover 12, an insect net 13, a smoke detection unit body 14, an element placement unit 15, a circuit board 16, a light emitting unit 17, and a light receiving unit 18 in FIG. 2. The circuit board 16 includes a light emission control circuit that drives the light emitting unit 17 to be described later, and a light reception processing circuit that processes a received light signal (photoelectrically converted signal) from the light receiving unit 18, and light emission-side connection portions 212 and light reception-side connection portions 312 to be described later are electrically connected to the light emission control circuit and the light reception processing circuit, respectively.

### (Configuration - outer cover, smoke detection unit cover, and insect net)

The outer cover 11 in FIG. 1 is a housing that houses components of the detector 100.

The smoke detection unit cover 12 in FIG. 2 forms a smoke detection space 122 (FIG. 1), and includes, for example, a labyrinth 121 that allows smoke to flow in or out of the smoke detection space 122 while shielding light from the outside.

The insect net 13 is a net that prevents insects from entering the smoke detection space 122, and has, for example, an annular shape to cover an outer periphery of the labyrinth 121.

### (Configuration - smoke detection unit body)

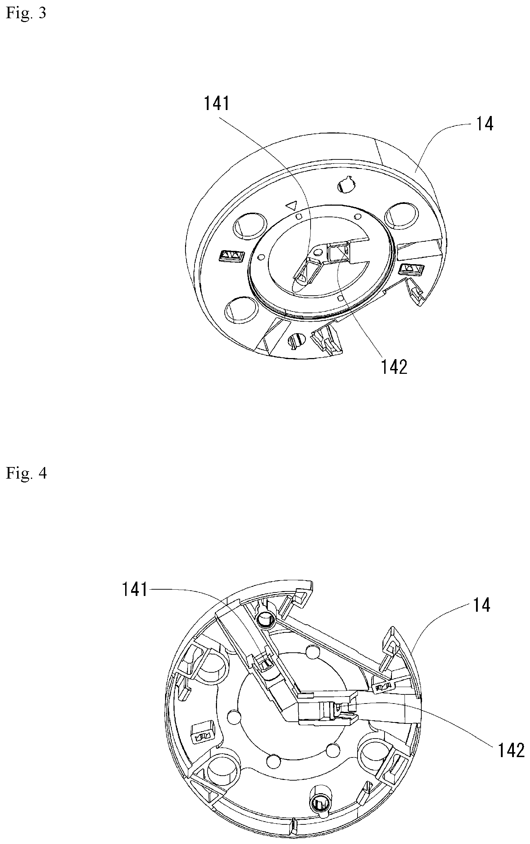

FIGS. 3 and 4 are perspective views of the smoke detection unit body. The smoke detection unit body 14 in FIG. 2 forms the smoke detection space 122 together with the smoke detection unit cover 12, and the circuit board 16 is attached to the smoke detection unit body 14. As shown in FIGS. 3 and 4, for example, the smoke detection unit body 14 includes an opening portion 141 for the light emitting element and an opening portion 142 for the light receiving element.

The opening portion 141 for the light emitting element is an opening portion for irradiating the smoke detection space 122 provided on a front side (side shown in FIG. 3) of the smoke detection unit body 14, with light from the light emitting unit 17 installed on a back side (side shown in FIG. 4) of the smoke detection unit body 14, and is, for example, an opening portion penetrating through the smoke detection unit body 14 from the back side to the front side.

The opening portion 142 for the light receiving element is an opening portion for irradiating the light receiving unit 18 installed on the back side of the smoke detection unit body 14, with light (specifically, scattered light) from the smoke detection space 122 provided on the front side of the smoke detection unit body 14, and is, for example, an opening portion penetrating through the smoke detection unit body 14 from the back side to the front side.

### (Configuration - element placement unit)

The element placement unit 15 in FIG. 2 is an element placement unit on which the light emitting unit 17 and the light receiving unit 18 are placed, and is, for example, mounted on the circuit board 16. Incidentally, details of the element placement unit 15 will be described later.

### (Configuration - circuit board)

The circuit board 16 in FIG. 2 is a board on which various electric circuits are mounted, and is, for example, a rigid board having a predetermined shape and provided on the back side of the smoke detection unit body 14.

### (Configuration - light emitting unit)

The light emitting unit 17 in FIG. 2 is a light emitting element that irradiates the smoke detection space 122 with light, and is, for example, a light emitting diode (LED).

### (Configuration - light receiving unit)

The light receiving unit 18 in FIG. 2 is a light receiving element irradiated with light (specifically, scattered light) from the smoke detection space 122 to detect the light, and is, for example, a photodiode (PD).

### (Configuration - details - element placement unit)

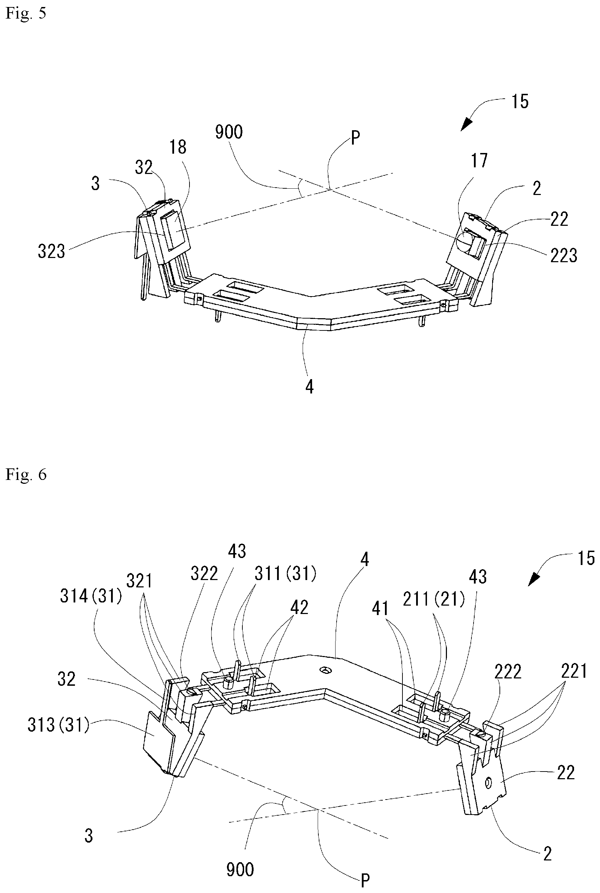

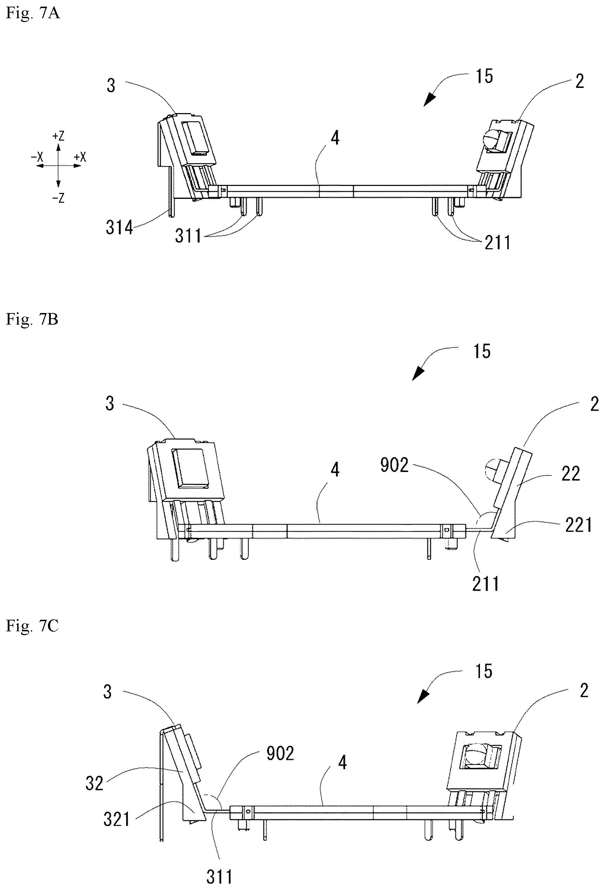

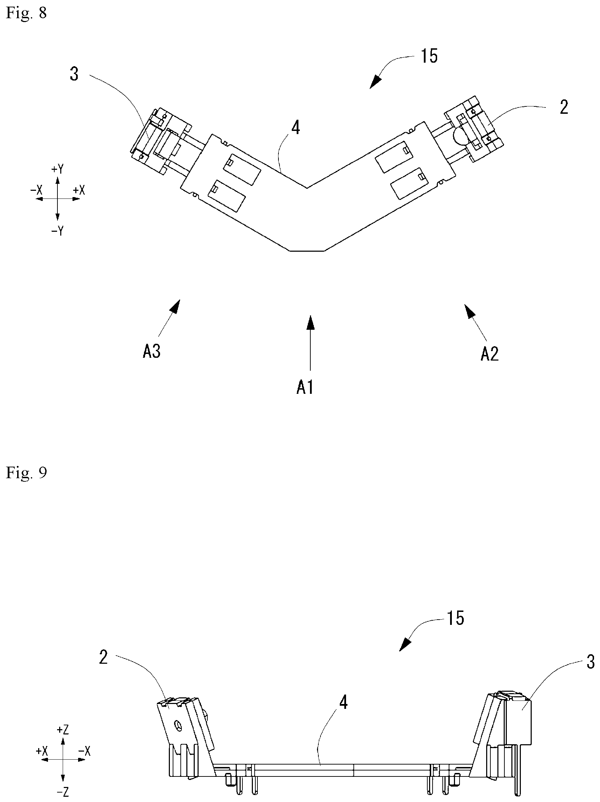

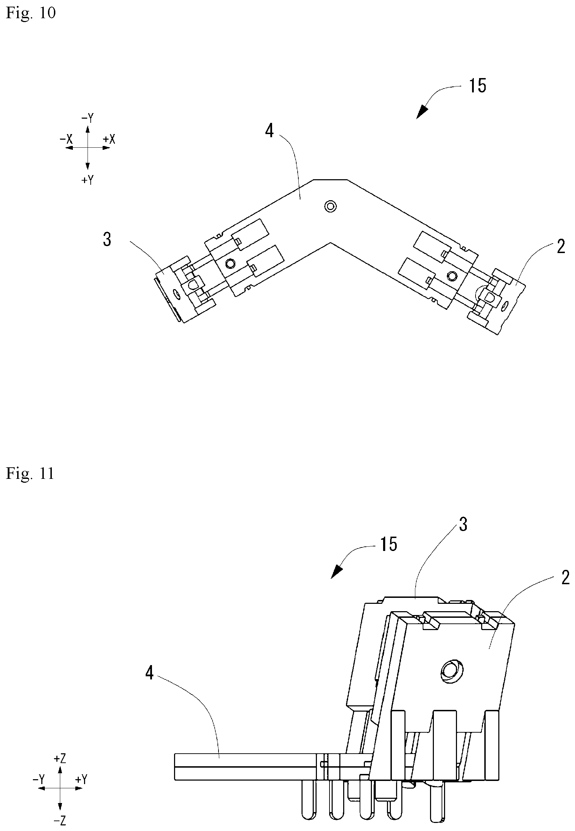

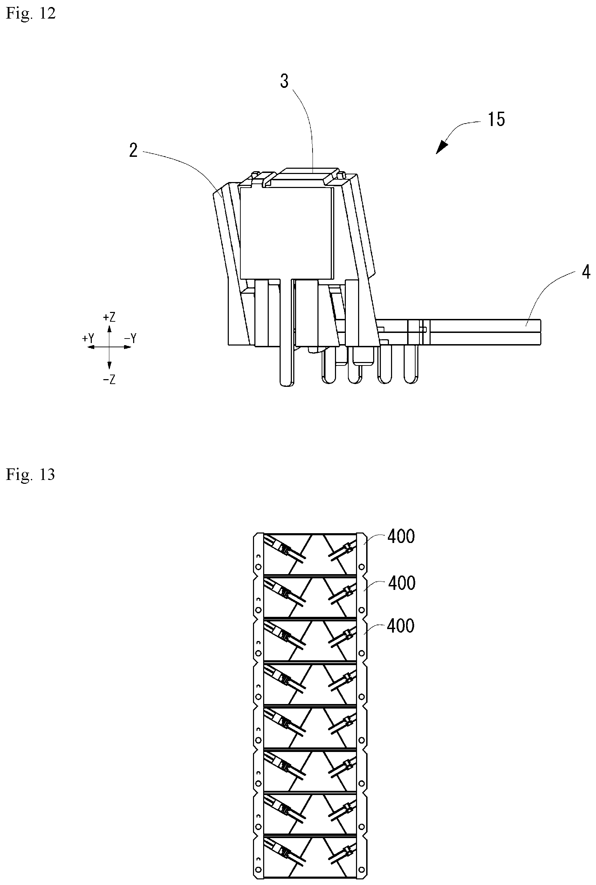

Next, details of the element placement unit 15 will be described. FIGS. 5 and 6 are perspective views of the element placement unit, FIGS. 7A to 7C are a front view of the element placement unit, FIG. 8 is a plan view of the element placement unit, FIG. 9 is a rear view of the element placement unit, FIG. 10 is a bottom view of the element placement unit, FIG. 11 is a right side view of the element placement unit, and FIG. 12 is a left side view of the element placement unit.

Incidentally, in FIGS. 5 and 6, optical axes of the light emitting unit 17 and the light receiving unit 18 are shown by alternating long and short dashed lines. **In** addition, it may be interpreted that the optical axis shown by an alternating long and short dashed line and extending from the light emitting unit 17 corresponds to a "light emitting axis" and the optical axis extending from the light receiving unit 18 corresponds to a "light receiving axis". **In** addition, FIGS. 7A, 7B, and 7C show states when viewed in a direction A1, a direction A2, and a direction A3 in FIG. 8. **In** addition, in FIGS. 7A to 12, X-Y-Z axes are described as being orthogonal to each other.

The element placement unit 15 in FIG. 2 is an element placement unit on which the light emitting unit 17 and the light receiving unit 18 are placed, and is, for example, attached and fixed to the circuit board 16. As shown in FIGS. 5 and 6, for example, the element placement unit 15 holds the light emitting unit 17 and the light receiving unit 18 so as to form a scattering angle 900 within a predetermined angle range.

The "scattering angle" 900 is an angle formed at an intersection point P where the optical axis of the light emitting unit 17 and the optical axis of the light receiving unit 18 intersect each other, is an angle represented by an intersection angle at the intersection point **P,** and specifically, is an angle on a plane passing through each of the optical axes forming the intersection point P. Incidentally, in the detector 100, actually, the intersection point P is formed in the smoke detection space 122 (FIG. 1).

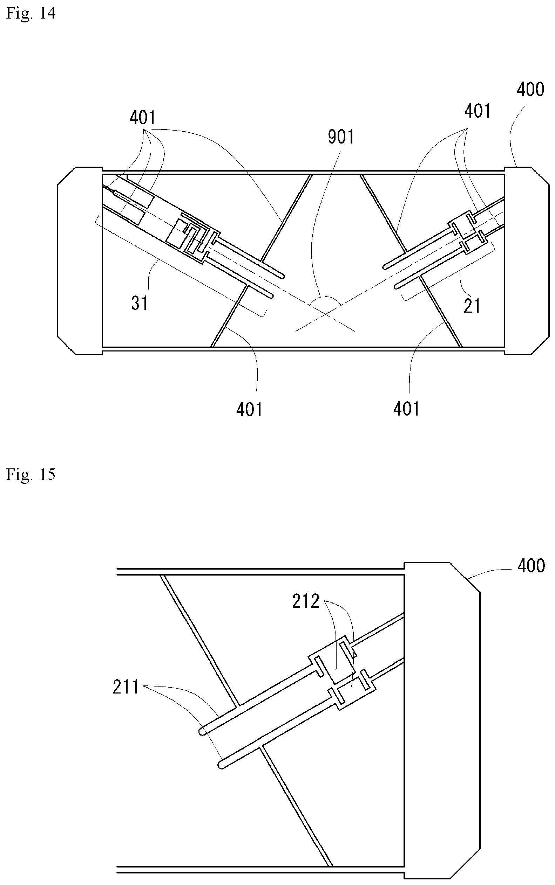

Further, the specific angle of the scattering angle 900 is any angle, but is preferably set to, for example, approximately 60 degrees to 90 degrees to reduce sensitivity differences for various smoke particle sizes, and in the present example, is configured to be within this angle range. In addition, in the present example, the angle of the scattering angle 900 is determined by a first element angle 901 (FIG. 14 to be described later) and second element angles 902 (FIGS. 7B and 7C).

Incidentally, as shown in FIG. 14 to be described later, the "first element angle" 901 is determined by directions in which a light emission-side electrode portion 21 and a light reception-side electrode portion 31 are directed in a lead frame 400.

In addition, as shown in FIGS. 7B and 7C, the "second element angles" 902 are determined by the inclination of a light emission-side holding portion 22 and a light reception-side holding portion 32 with respect to a holding member 4. Incidentally, the angles of the two second element angles 902 may be the same angle as each other or may be angles different from each other.

The element placement unit 15 in FIGS. 5 and 6 includes, for example, a light emission-side placement portion 2, a light reception-side placement portion 3, and the holding member 4.

### (Configuration - details - element placement unit - light emission-side placement portion)

The light emission-side placement portion 2 in FIGS. 5 and 6 is a portion for mounting the light emitting unit 17 on the circuit board 16, and includes, for example, the light emission-side electrode portion 21 (also refer to FIG. 14 to be described later) and the light emission-side holding portion 22 (FIGS. 5 and 6).

### (Configuration - details - element placement unit - light emission-side placement portion - light emission-side electrode portion)

The light emission-side electrode portion 21 (also refer to FIG. 14 to be described later) is a light emitting element-side electrode portion having conductivity for placing the light emitting unit 17 on the circuit board 16 while electrically connecting the light emitting unit 17 to an electric circuit of the circuit board 16, and is, for example, a metal portion. The light emission-side electrode portion 21 includes, for example, light emission-side lead portions 211 (FIG. 6) and the light emission-side connection portions 212 (also refer to FIG. 15 to be described later).

The light emission-side lead portions 211 are conductive wires electrically connected to an anode terminal and a cathode terminal of the light emitting unit 17 mounted on the light emission-side placement portion 2, and parts of the light emission-side lead portions 211 are held by the holding member 4. As shown in FIG. 6, for example, parts on a tip side of the light emission-side lead portions 211 are folded inside an opening portion 41 for the light emission-side leads, and protrude toward the back side (-Z direction in FIG. 7A and the like). As shown in FIG. 7B parts on an opposite side of the light emission-side lead portions 211 from the tip side are folded by the second element angle 902.

The light emission-side connection portions 212 (also refer to FIG. 15 to be described later) are portions that are continuous from the light emission-side lead portions 211, and are portions with which the anode terminal and the cathode terminal of the light emitting unit 17 mounted on the light emission-side placement portion 2 come into contact, and which are electrically connected thereto.

### (Configuration - details - element placement unit - light emission-side placement portion - light emission-side holding portion)

The light emission-side holding portion 22 in FIGS. 5 and 6 is an insulating portion (for example, a resin portion) that holds a part of the light emission-side electrode portion 21, is a portion having a substantially rectangular shape as a whole, and includes a light emission-side support portion 221 (FIG. 6), a light emission-side protrusion portion 222 (FIG. 6), and a light emission-side opening portion 223 (FIG. 5).

The light emission-side support portion 221 is a support portion that supports the light emission-side holding portion 22, and is, for example, a portion configured to support the light emission-side holding portion 22 in a state where the light emission-side holding portion 22 is inclined by the second element angle 902 with respect to the holding member 4 (FIG. 7B) provided on the circuit board 16 and parallel to the circuit board 16.

The light emission-side protrusion portion 222 is a protrusion portion for positioning the light emission-side placement portion 2 with respect to the circuit board 16, and is, for example, a portion inserted into a hole or groove provided at a predetermined position on the circuit board 16.

The light emission-side opening portion 223 is a substantially rectangular opening portion provided at a position on the light emission-side holding portion 22 where the light emitting unit 17 is attached, and is, for example, an opening portion that exposes the light emission-side connection portions 212 (also refer to FIG. 15 to be described later).

### (Configuration - details - element placement unit - light reception-side placement portion)

The light reception-side placement portion 3 in FIGS. 5 and 6 is a portion for mounting the light receiving unit 18 on the circuit board 16, and includes, for example, the light reception-side electrode portion 31 (also refer to FIG. 14 to be described later) and the light reception-side holding portion 32 (FIGS. 5 and 6).

### (Configuration - details - element placement unit - light reception-side placement portion - light reception-side electrode portion)

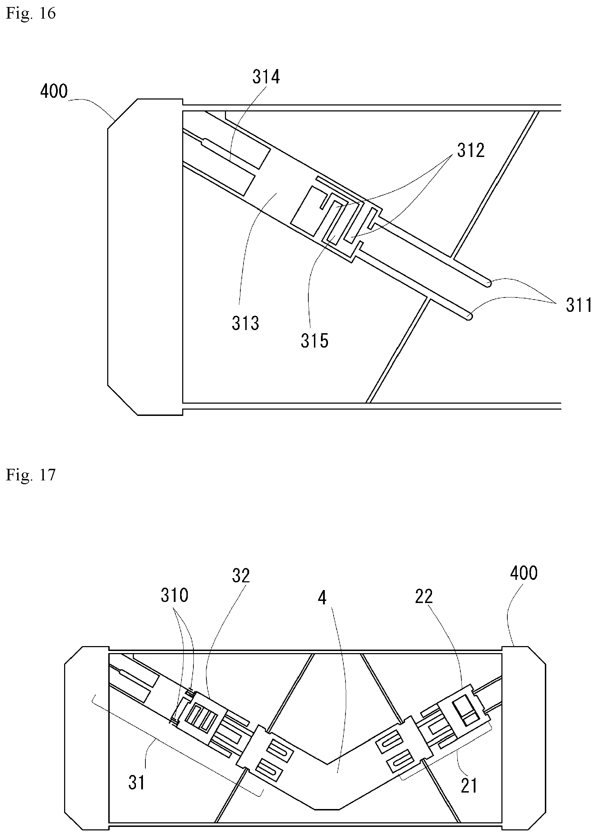

The light reception-side electrode portion 31 (also refer to FIG. 14 to be described later) is a light receiving element-side electrode portion having conductivity for placing the light receiving unit 18 on the circuit board 16 while electrically connecting the light receiving unit 18 to an electric circuit of the circuit board 16, and is, for example, a metal portion. The light reception-side electrode portion 31 includes, for example, light reception-side lead portions 311 (FIG. 6), the light reception-side connection portions 312 (also refer to FIG. 16 to be described later), a shield portion 313 (FIG. 6), a shield-side lead portion 314 (FIG. 6), and a shield-side connection portion 315 (also refer to FIG. 16 to be described later).

The light reception-side lead portions 311 are conductive wires electrically connected to an anode terminal and a cathode terminal of the light receiving unit 18 mounted on the light reception-side placement portion 3, and parts of the light reception-side lead portions 311 are held by the holding member 4. As shown in FIG. 6, for example, parts on a tip side of the light reception-side lead portions 311 are folded inside an opening portion 42 for the light reception-side leads, and protrude toward the back side (-Z direction in FIG. 7A and the like). As shown in FIG. 7C, parts on an opposite side of the light reception-side lead portions 311 from the tip side are folded by the second element angle 902.

The light reception-side connection portions 312 (also refer to FIG. 16 to be described later) are portions that are continuous from the light reception-side lead portions 311, and are portions with which the anode terminal and the cathode terminal of the light receiving unit 18 mounted on the light reception-side placement portion 3 come into contact, and which are electrically connected thereto.

The shield portion 313 is a shield portion functioning as a shield for the prevention of noise or the reduction of noise of the light receiving unit 18 mounted on the light reception-side placement portion 3, and is a portion provided on a back side of the light receiving unit 18. In addition, the shield portion 313 is a portion formed by extending from a part of the light reception-side electrode portion 31.

The shield-side lead portion 314 is a conductive wire electrically connected to the shield portion 313, and is, for example, a portion of which a tip side protrudes toward the back side (-Z direction in FIG. 7A and the like).

The shield-side connection portion 315 (also refer to FIG. 16 to be described later) is a portion that is continuous from the shield portion 313, and is a portion that comes into contact with a case of the light receiving unit 18 mounted on the light reception-side placement portion 3.

### (Configuration - details - element placement unit - light reception-side placement portion - light reception-side holding portion)

The light reception-side holding portion 32 in FIGS. 5 and 6 is an insulating portion (for example, a resin portion) that holds a part of the light reception-side electrode portion 31, is a portion having a substantially rectangular shape as a whole, and includes a light reception-side support portion 321 (FIG. 6), a light reception-side protrusion portion 322 (FIG. 6), and a light reception-side opening portion 323 (FIG. 5).

The light reception-side support portion 321 is a support portion that supports the light reception-side holding portion 32, and is, for example, a portion configured to support the light reception-side holding portion 32 in a state where the light reception-side holding portion 32 is inclined by the second element angle 902 with respect to the holding member 4 (FIG. 7C) provided on the circuit board 16 and parallel to the circuit board 16.

The light reception-side protrusion portion 322 is a protrusion portion for positioning the light reception-side placement portion 3 with respect to the circuit board 16, and is, for example, a portion inserted into a hole or groove provided at a predetermined position on the circuit board 16.

The light reception-side opening portion 323 is a substantially rectangular opening portion provided at a position on the light reception-side holding portion 32 where the light receiving unit 18 is attached, and is, for example, an opening portion that exposes the light reception-side connection portions 312 and the shield-side connection portion 315 (also refer to FIG. 16 to be described later).

### (Configuration - details - element placement unit - holding member)

The holding member 4 in FIG. 6 is an insulating member (for example, a resin member) that holds the light emission-side electrode portion 21 and the light reception-side electrode portion 31, and as shown in FIG. 8, for example, is an insulating member bent to form a predetermined angle (specifically, the first element angle 901 (FIG. 14 to be described later)) in a plan view.

As shown in FIG. 6, for example, the holding member 4 includes the opening portion 41 for the light emission-side leads, the opening portion 42 for the light reception-side leads, and a holding member-side protrusion portion 43.

The opening portion 41 for the light emission-side leads is a penetrating opening portion provided at a position toward the light emission-side holding portion 22, and is an opening portion inside which the parts on the tip side of the light emission-side lead portions 211 are disposed.

The opening portion 42 for the light reception-side leads is a penetrating opening portion provided at a position toward the light reception-side holding portion 32, and is an opening portion inside which the parts on the tip side of the light reception-side lead portions 311 are disposed.

The holding member-side protrusion portion 43 is a protrusion portion for positioning the holding member 4 with respect to the circuit board 16, and is, for example, a portion inserted into a hole or groove provided at a predetermined position on the circuit board 16.

### (Method for manufacturing element placement unit)

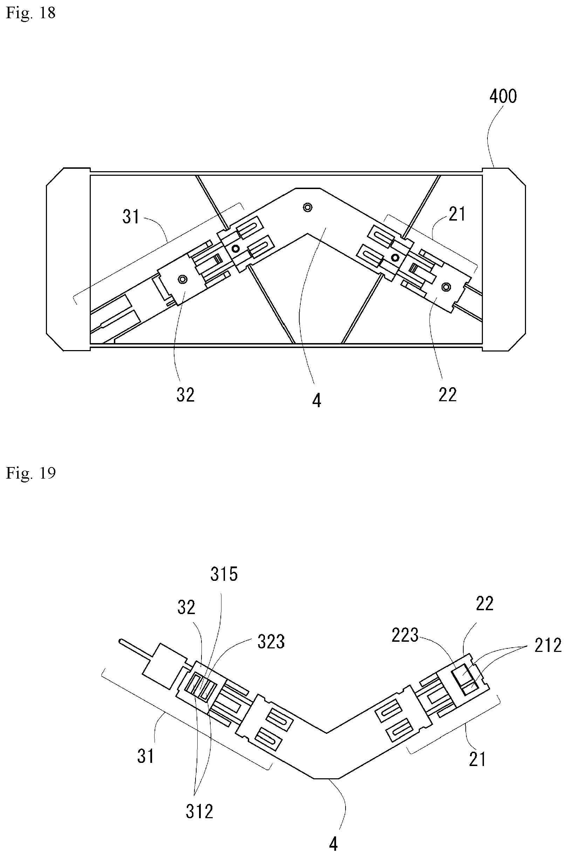

Next, a method for manufacturing the element placement unit 15 configured in such a manner will be described. FIG. 13 is a plan view of a plurality of lead frames, FIG. 14 is a plan view of one lead frame, FIGS. 15 and 16 are partial enlarged views of FIG. 14, FIG. 17 is a plan view showing a lead frame with the holding member and the like are formed thereon, FIG. 18 is a bottom view showing the lead frame with the holding member and the like are formed thereon, and FIG. 19 is a plan view showing the separated holding member and the like.

Incidentally, the "lead frame" 400 is a lead frame body, schematically, is a metal object, and includes, for example, elements forming at least a part of the element placement unit 15.

### = = = Formation of light emission-side electrode portion and light reception-side electrode portion = = =

First, as shown in FIG. 14, the light emission-side electrode portion 21 and the light reception-side electrode portion 31 are formed. Incidentally, during actual manufacturing, a plurality of the lead frames 400 each including the light emission-side electrode portion 21 and the light reception-side electrode portion 31 are collectively formed; however, in the present embodiment, one lead frame 400 will be focused and described. Here, for example, as shown in FIGS. 14 to 16, the light emission-side electrode portion 21 and the light reception-side electrode portion 31 made of metal with a predetermined thickness (for example, approximately 1 mm to 3 mm or the like) are integrally formed on one lead frame 400 using any method (for example, a method for pressing metal using a mold or other known methods).

Particularly, as shown in FIG. 14, the light emission-side electrode portion 21 and the light reception-side electrode portion 31 are formed such that the first element angle 901 that is an angle determined by the directions in which the electrode portions extend (directions shown by alternating long and short dashed lines in FIG. 14) can form the scattering angle 900 of an appropriate angle (FIGS. 5 and 6) (namely, as described above, for example, the scattering angle 900 of approximately 60 degrees to 90 degrees), but as one example, may be formed such that the first element angle 901 becomes 120 degrees.

Incidentally, here, for example, in order to fix the light emission-side electrode portion 21 and the light reception-side electrode portion 31 to the lead frame 400, a plurality of fixing portions 401 are also integrally formed.

In addition, here, for example, the light emission-side electrode portion 21 and the light reception-side electrode portion 31 may be simultaneously formed, or after the light emission-side electrode portion 21 is formed, the light reception-side electrode portion 31 may be formed, or conversely, after the light reception-side electrode portion 31 is formed, the light emission-side electrode portion 21 may be formed.

### = = = Holding of light emission-side electrode portion and light reception-side electrode portion = = =

Next, as shown in FIGS. 17 and 18, the light emission-side electrode portion 21 and the light reception-side electrode portion 31 (FIG. 14) are held by the common holding member 4. Here, for example, as shown in FIGS. 17 and 18, the holding member 4, the light emission-side holding portion 22, and the light reception-side holding portion 32 are integrally formed on one lead frame 400 using any method (for example, a method using insert molding or other known methods).

Incidentally, here, for example, the holding member 4, the light emission-side holding portion 22, and the light reception-side holding portion 32 may be simultaneously formed, or may be sequentially formed in any order.

### = = = Separation of holding member and the like = = =

Next, as shown in FIG. 19, the light emission-side electrode portion 21, the light reception-side electrode portion 31, the holding member 4, the light emission-side holding portion 22, and the light reception-side holding portion 32 (hereinafter, also referred to as "each element of the element placement unit 15") are separated from other portions of the lead frame 400. Here, for example, each element of the element placement unit 15 is separated by cutting connection portions with the plurality of fixing portions 401 shown in FIG. 14.

Incidentally, here, for example, two removal portions 310 shown in FIG. 17 as a part of the light reception-side electrode portion 31 are also removed. For example, since each of two light reception-side lead portions 311 in FIG. 16 is separated from the shield portion 313 by this procedure, the two light reception-side lead portions 311 are electrically separated from each other.

### = = = Folding of lead portion (namely, bending of lead portion) = = =

Next, as shown in FIGS. 5 to 12, the element placement unit 15 is formed by folding the light emission-side electrode portion 21 and the light reception-side electrode portion 31 at predetermined positions. Accordingly, the element placement unit 15 is manufactured.

### (Method for manufacturing detector)

Next, a method for manufacturing the detector 1 will be described.

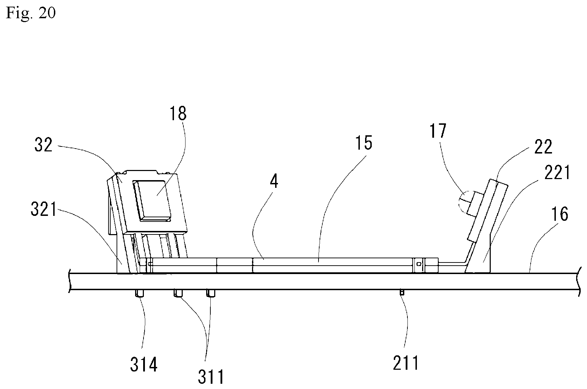

FIG. 20 is a front view showing the circuit board on which the element placement unit is mounted. Incidentally, a hole or groove into which each protrusion portion of the element placement unit 15 is inserted for positioning is provided in a surface (upper surface of the drawing of FIG. 20) of the circuit board 16, and the circuit board 16 is provided with insertion holes into which the light emission-side lead portions 211, the light reception-side lead portions 311, and the shield-side lead portion 314 provided in the positioned element placement unit 15 are inserted.

### = = = Mounting of each element = = =

First, the light emitting unit 17 and the light receiving unit 18 are mounted on the element placement unit 15 manufactured as described above. Here, for example, as shown in FIG. 5, the light emitting unit 17 is provided in the light emission-side opening portion 223 (also refer to FIG. 19), and the light receiving unit 18 is provided in the light reception-side opening portion 323 (also refer to FIG. 19). The specific fixing method is any method, but for example, fixing may be performed by engagement or fixing may be performed using an adhesive agent (incidentally, unless otherwise specified, the same applies to a method for fixing other elements).

In this case, for example, the anode terminal and the cathode terminal of the light emitting unit 17 are electrically connected to the light emission-side connection portions 212 in FIG. 19, namely, are electrically connected to the light emission-side lead portions 211 (FIG. 6).

In addition, in this case, for example, the anode terminal and the cathode terminal of the light receiving unit 18 are electrically connected to the light reception-side connection portions 312 in FIG. 19, namely, are electrically connected to the light reception-side lead portions 311 (FIG. 6).

### = = = Mounting of element placement unit = = =

Next, as shown in FIG. 20, the element placement unit 15 is mounted by being fixed to the circuit board 16. Here, for example, the element placement unit 15 is positioned by inserting each protrusion portion of the element placement unit 15 into the positioning hole or groove of the circuit board 16, and tip sides of the light emission-side lead portions 211, the light reception-side lead portions 311, and the shield-side lead portion 314 are inserted and fixed to the insertion holes of the circuit board 16.

Incidentally, in this case, since the holding member 4 is parallel to the circuit board 16 and the light emission-side holding portion 22 and the light reception-side holding portion 32 are supported by the light emission-side support portion 221 and the light reception-side support portion 321, as shown in FIGS. 7B and 7C, a state where the second element angle 902 is a predetermined angle (angle determined in advance at which the angle of the scattering angle 900 (FIGS. 5 and 6) is, for example, approximately 60 degrees to 90 degrees) is maintained.

Thereafter, the mounting of the element placement unit 15 is completed by connecting the light emission-side lead portions 211, the light reception-side lead portions 311, and the shield-side lead portion 314 protruding from a back surface (lower surface of the drawing of FIG. 20) of the circuit board 16 in FIG. 20, to the electric circuits (including wiring patterns) of the circuit board 16, a ground pattern, or the like using solder or the like.

### = = = Attachment of each element = = =

Next, as shown in FIG. 2, the circuit board 16 with the element placement unit 15 mounted thereon is fixed to the back side of the smoke detection unit body 14 using any method (for example, a fixing method using fixing screws or the like). Incidentally, in this case, the optical axes of the light emitting unit 17 and the light receiving unit 18 shown in FIGS. 5 and 6 pass through the opening portion 141 for the light emitting element and the opening portion 142 for the light receiving element in FIGS. 3 and 4, and reach the front side of the smoke detection unit body 14.

Next, the smoke detection unit cover 12 with the insect net 13 attached thereto is fixed to the front side of the smoke detection unit body 14 using any method (for example, a fixing method by engaging attachment projections, a method using an adhesive agent, or the like).

Next, the outer cover 11 (FIG. 1) is fixed to the smoke detection unit body 14 and the like using any method (for example, a fixing method using fixing screws or the like). Further, in this case, the smoke detection space 122 shown in FIG. 1 is formed, and the intersection point P in FIGS. 5 and 6 are provided in the smoke detection space 122. Accordingly, the detector 1 is manufactured.

### (Operation of detector)

Next, the operation of the detector 1 will be described. Since the operation of the detector 1 is known, only a brief description will be given. Here, for example, as shown in FIG. 1, a case where the detector 100 is installed on a ceiling will be described.

When a fire has occurred in the monitoring target region, smoke particles flow into the smoke detection space 122 via opening portions of the outer cover 11 of the detector 100. In this case, light output from the light emitting unit 17 in FIGS. 5 and 6 is scattered by the smoke particles that have flowed in, and scattered light that is light caused by the scattering is detected by the light receiving unit 18, so that the detector 100 detects the fire.

### (Effects of embodiment)

As described above, according to the present embodiment, by providing the light emission-side electrode portion 21 and the light reception-side electrode portion 31, for example, the light emitting unit 17 and the light receiving unit 18 can be easily attached to the detector 100. In addition, by integrally forming the light emission-side electrode portion 21 and the light reception-side electrode portion 31 on the common lead frame 400, for example, the element placement unit 15 can be easily formed.

In addition, by disposing the light emission-side electrode portion 21 and the light reception-side electrode portion 31 so as to correspond to the first element angle 901 forming the scattering angle 900, for example, the scattering angle 900 of an appropriate angle (for example, approximately 60 degrees to 90 degrees) can be reliably and easily formed in the detector 100.

In addition, by integrally forming the shield portion 313 on the lead frame 400, for example, a shield for the light receiving unit 18 can be provided in the element placement unit 15.

In addition, by forming the shield portion 313 through extending from a part of the light reception-side electrode portion 31, for example, the shield portion 313 can be formed integrally with the light reception-side electrode portion 31, and the shield portion 313 can be easily formed.

In addition, by providing the holding member 4 that holds the light emission-side electrode portion 21 and the light reception-side electrode portion 31, for example, the light emission-side electrode portion 21, the light reception-side electrode portion 31, and the holding member 4 can be integrated into one unit, and handling can be facilitated.

In addition, by electrically connecting the light emitting unit 17 and the light receiving unit 18 to the electric circuits of the circuit board 16 of the detector 100 via the light emission-side lead portions 211 and the light reception-side lead portions 311, for example, the light emitting unit 17 and the light receiving unit 18 can be reliably and easily electrically connected to the electric circuits.

In addition, by electrically connecting the shield portion 313 to an electric circuit ground (predetermined circuit ground) of the circuit board 16 of the detector 100, for example, the electromagnetic shielding effect of the shield portion 313 (the effect of preventing an influence of electrical or magnetic disturbance noise on the element or the effect of reducing the influence) can be improved.

In addition, by forming the light emission-side electrode portion 21 and by forming the light reception-side electrode portion 31, for example, the light emitting unit 17 and the light receiving unit 18 can be easily attached to the detector 100. In addition, by integrally forming the light emission-side electrode portion 21 and the light reception-side electrode portion 31 on the common lead frame 400, for example, the element placement unit 15 can be easily formed.

In addition, by holding the light emission-side electrode portion 21 and the light reception-side electrode portion 31 using the common holding member 4, and by separating the light emission-side electrode portion 21, the light reception-side electrode portion 31, and the holding member 4 from the common lead frame 400, for example, the light emission-side electrode portion 21, the light reception-side electrode portion 31, and the holding member 4 can be integrated into one unit, and can be easily separated from the common lead frame 400.

In addition, by bending the light emission-side electrode portion 21 and the light reception-side electrode portion 31 according to the scattering angle, for example, the scattering angle 900 of an appropriate angle (for example, approximately 60 degrees to 90 degrees) can be reliably and easily formed in the detector 100.

In addition, the element placement unit 15, in which the light emitting unit 17 and the light receiving unit 18 are placed to be electrically connected to the light emission-side electrode portion 21 and the light reception-side electrode portion 31 integrally held by the holding member 4 respectively, is electrically connected to the electric circuits of the circuit board of the detector 100, so that for example, the light emitting unit 17 and the light receiving unit 18 can be easily attached to the detector 100. In addition, by electrically connecting the light emitting unit 17 and the light receiving unit 18 via the light emission-side lead portions 211 and the light reception-side lead portions 311, for example, the light emitting unit 17 and the light receiving unit 18 can be reliably and easily electrically connected to the electric circuits.

2: light emission-side placement portion
3: light reception-side placement portion
4: holding member
11: outer cover
12: smoke detection unit cover
13: insect net
14: smoke detection unit body
15: element placement unit
16: circuit board
17: light emitting unit
18: light receiving unit
21: light emission-side electrode portion
22: light emission-side holding portion
31: light reception-side electrode portion
32: light reception-side holding portion
41: opening portion for light emission-side leads
42: opening portion for light reception-side leads
43: holding member-side protrusion portion
100: detector
121: labyrinth
122: smoke detection space
141: opening portion for light emitting element
142: opening portion for light receiving element
211: light emission-side lead portion
212: light emission-side connection portion
221: light emission-side support portion
222: light emission-side protrusion portion
223: light emission-side opening portion
311: light reception-side lead portion
312: light reception-side connection portion
313: shield portion
314: shield-side lead portion
315: shield-side connection portion
321: light reception-side support portion
322: light reception-side protrusion portion
323: light reception-side opening portion
400: lead frame
401: fixing portion
900: scattering angle
901: first element angle
902: second element angle
P: intersection point

## Claims

1. A method for manufacturing an electrode portion in an element placement unit for placing a light emitting element (17) and a light receiving element (18) of a smoke detector (100) that detects smoke by receiving scattered light caused by a scattering of light from the light emitting element (17) by the smoke, using the light receiving element (18), the method comprising:
a step of integrally forming a light emitting element-side electrode portion (21) having conductivity on a common frame body, the light emitting element-side electrode portion (21) for placing the light emitting element while electrically connecting the light emitting element (17); and
a step of integrally forming a light receiving element-side electrode portion (31) having conductivity on the common frame body, the light receiving element-side electrode portion (31) for placing the light receiving element while electrically connecting the light receiving element (18),
**characterized by**
a step of holding the light emitting element-side electrode portion (21) and the light receiving element-side electrode portion (31) in the common frame body using a common insulating member; and
a step of separating the light emitting element-side electrode portion (21), the light receiving element-side electrode portion (31), and the common insulating member from the common frame body.

2. The method for manufacturing an electrode portion according to claim 1,
wherein the light emitting element-side electrode portion (21) and the light receiving element-side electrode portion (31) are disposed to correspond to a first element angle forming a scattering angle (900) represented by an intersection angle between a light emitting axis of the light emitting element (17) and a light receiving axis of the light receiving element (18).

3. The method for manufacturing an electrode portion according to claim 1, the method comprising:
a step of forming a shield portion (313) integrally with the light emitting element-side electrode portion (21) and the light receiving element-side electrode portion (31) on the common frame body, the shield portion (313) functioning as an electromagnetic shield for the light receiving element (18).

4. The method for manufacturing an electrode portion according to claim 1, further comprising:
a step of bending the light emitting element-side electrode portion (21) or the light receiving element-side electrode portion (31) according to a scattering angle (900) represented by an intersection angle between a light emitting axis of the light emitting element (17) and a light receiving axis of the light receiving element (18).

## Patentansprüche

1. Verfahren zur Herstellung eines Elektrodenabschnitts in einer Elementplatzierungseinheit zum Platzieren eines lichtemittierenden Elements (17) und eines lichtempfangenden Elements (18) eines Rauchmelders (100), der Rauch durch Empfangen von Streulicht erfasst, das durch eine Streuung von Licht von dem lichtemittierenden Element (17) durch den Rauch verursacht wird, unter Verwendung des lichtempfangenden Elements (18), wobei das Verfahren umfasst:
einen Schritt des einstückigen Ausbildens eines eine Leitfähigkeit aufweisenden Elektrodenabschnitts (21) auf der Seite des lichtemittierenden Elements an einem gemeinsamen Rahmenkörper, wobei der Elektrodenabschnitt (21) auf der Seite des lichtemittierenden Elements zum Platzieren des lichtemittierenden Elements bei gleichzeitigem elektrischem Verbinden des lichtemittierenden Elements (17) dient; und
einen Schritt des einstückigen Ausbildens eines eine Leitfähigkeit aufweisenden Elektrodenabschnitts (31) auf der Seite des lichtempfangenden Elements an dem gemeinsamen Rahmenkörper, wobei der Elektrodenabschnitt (31) auf der Seite des lichtempfangenden Elements zum Platzieren des lichtempfangenden Elements bei gleichzeitigem elektrischem Verbinden des lichtempfangenden Elements (18) dient,
**gekennzeichnet durch**
einen Schritt des Haltens des Elektrodenabschnitts (21) auf der Seite des lichtemittierenden Elements und des Elektrodenabschnitts (31) auf der Seite des lichtempfangenden Elements in dem gemeinsamen Rahmenkörper unter Verwendung eines gemeinsamen Isolierelements; und
einen Schritt des Trennens des Elektrodenabschnitts (21) auf der Seite des lichtemittierenden Elements, des Elektrodenabschnitts (31) auf der Seite des lichtempfangenden Elements und des gemeinsamen Isolierelements von dem gemeinsamen Rahmenkörper.

2. Verfahren zur Herstellung eines Elektrodenabschnitts nach Anspruch 1,
wobei der Elektrodenabschnitt (21) auf der Seite des lichtemittierenden Elements und der Elektrodenabschnitt (31) auf der Seite des lichtempfangenden Elements so angeordnet sind, dass sie einem ersten Elementwinkel entsprechen, der einen Streuwinkel (900) bildet, der durch einen Schnittwinkel zwischen einer Lichtemissionsachse des lichtemittierenden Elements (17) und einer Lichtempfangsachse des lichtempfangenden Elements (18) dargestellt wird.

3. Verfahren zur Herstellung eines Elektrodenabschnitts nach Anspruch 1, wobei das Verfahren umfasst:
einen Schritt des einstückigen Ausbildens eines Abschirmabschnitts (313) mit dem Elektrodenabschnitt (21) auf der Seite des lichtemittierenden Elements und dem Elektrodenabschnitt (31) auf der Seite des lichtempfangenden Elements an dem gemeinsamen Rahmenkörper, wobei der Abschirmabschnitt (313) als eine elektromagnetische Abschirmung für das lichtempfangende Element (18) fungiert.

4. Verfahren zur Herstellung eines Elektrodenabschnitts nach Anspruch 1, ferner umfassend:
einen Schritt des Biegens des Elektrodenabschnitts (21) auf der Seite des lichtemittierenden Elements oder des Elektrodenabschnitts (31) auf der Seite des lichtempfangenden Elements gemäß einem Streuwinkel (900), der durch einen Schnittwinkel zwischen einer Lichtemissionsachse des lichtemittierenden Elements (17) und einer Lichtempfangsachse des lichtempfangenden Elements (18) dargestellt wird.

## Revendications

1. Procédé de fabrication d'une portion d'électrode dans une unité de placement d'élément pour placer un élément émetteur de lumière (17) et un élément récepteur de lumière (18) d'un détecteur de fumée (100) qui détecte de la fumée en recevant de la lumière diffusée causée par une diffusion de lumière à partir de l'élément émetteur de lumière (17) par la fumée, en utilisant l'élément récepteur de lumière (18), le procédé comprenant :
une étape de formation d'un seul tenant d'une portion d'électrode (21) côté élément émetteur de lumière présentant une conductivité sur un corps de cadre commun, la portion d'électrode (21) côté élément émetteur de lumière servant à placer l'élément émetteur de lumière tout en connectant électriquement l'élément émetteur de lumière (17) ; et
une étape de formation d'un seul tenant d'une portion d'électrode (31) côté élément récepteur de lumière présentant une conductivité sur le corps de cadre commun, la portion d'électrode (31) côté élément récepteur de lumière servant à placer l'élément récepteur de lumière tout en connectant électriquement l'élément récepteur de lumière (18),
**caractérisé par**
une étape de maintien de la portion d'électrode (21) côté élément émetteur de lumière et la portion d'électrode (31) côté élément récepteur de lumière dans le corps de cadre commun en utilisant un organe isolant commun ; et
une étape de séparation de la portion d'électrode (21) côté élément émetteur de lumière, de la portion d'électrode (31) côté élément récepteur de lumière et de l'organe isolant commun du corps de cadre commun.

2. Procédé de fabrication d'une portion d'électrode selon la revendication 1,
dans lequel la portion d'électrode (21) côté élément émetteur de lumière et la portion d'électrode (31) côté élément récepteur de lumière sont disposées pour correspondre à un premier angle d'élément formant un angle de diffusion (900) représenté par un angle d'intersection entre un axe d'émission de lumière de l'élément émetteur de lumière (17) et un axe de réception de lumière de l'élément récepteur de lumière (18).

3. Procédé de fabrication d'une portion d'électrode selon la revendication 1, le procédé comprenant :
une étape de formation d'une portion de blindage (313) d'un seul tenant avec la portion d'électrode (21) côté élément émetteur de lumière et la portion d'électrode (31) côté élément récepteur de lumière sur le corps de cadre commun, la portion de blindage (313) fonctionnant comme un blindage électromagnétique pour l'élément récepteur de lumière (18).

4. Procédé de fabrication d'une portion d'électrode selon la revendication 1, comprenant en outre :
une étape de pliage de la portion d'électrode (21) côté élément émetteur de lumière ou de la portion d'électrode (31) côté élément récepteur de lumière selon un angle de diffusion (900) représenté par un angle d'intersection entre un axe d'émission de lumière de l'élément émetteur de lumière (17) et un axe de réception de lumière de l'élément récepteur de lumière (18).
